# EUROPÄISCHE PATENTSCHRIFT

(11) **EP 2 104 411 B1**
(45) Veröffentlichungstag und Bekanntmachung des Hinweises auf die Patenterteilung: **02.11.2011**
(21) Anmeldenummer: 08005434.9
(22) Anmeldetag: 22.03.2008
(51) Int. Cl.: H05K 7/20

(54) **Kühlsystem zur Kühlung von Flachdisplays mit einer Vorsatzscheibe**
Cooling system for cooling flat displays with a shield pane
Système de refroidissement d'écrans plats dotés d'un verre de protection

(43) Veröffentlichungstag der Anmeldung: 23.09.2009
(73) Patentinhaber: Conrac GmbH, 97990 Weikersheim (DE)
(72) Erfinder: Bernhardt, Jürgen, 97990 Weikersheim (DE)
(74) Vertreter: Karakatsanis, Georgios

(56) Entgegenhaltungen:
- FR-A- 2 891 940
- GB-A- 2 402 205
- US-A- 5 991 153
- US-A1- 2002 014 840

## Beschreibung

Die vorliegende Erfindung bezieht sich auf ein Kühlsystem zur Kühlung von Flachdisplays mit einer Vorsatzscheibe gemäß dem Oberbegriff des Patentanspruchs 1.

Flachdisplays, beispielsweise Displays umfassend ein TFT-Modul, sind heutzutage aufgrund des geringen Gewichts, der geringen Einbautiefe, der Strahlungsarmut und der guten Bildqualität sehr beliebt.

Flachdisplays umfassend eine Vorsatzscheibe werden nach dem Stand der Technik mittels eines Kreislaufs umfassend einen Luftfilter gekühlt, was in nachteiliger Weise in kurzen Wartungsintervallen und hohen Kosten resultiert. Durch den Luftfilter soll das Eindringen von Staub auf der Displaymodulvorderseite verhindert werden.

US 5 991 153 offenbart ein Kühlsystem zur Kühlung von Flachdisplays mit einer Vorsatzscheibe, das einen offenen Kühlkreislauf und einen geschlossenen Kühlkreislauf umfasst.

Der vorliegenden Erfindung liegt die Aufgabe zugrunde, ein Kühlsystem zur Kühlung von Flachdisplays mit einer Vorsatzscheibe anzugeben, welches eine effektive Kühlung sowohl der Vorderseite als auch der Rückseite des Displaymoduls unterhalb der vom Displayhersteller angegebenen maximalen Temperatur ermöglicht und wartungsfrei ist. Zudem soll das erfindungsgemäße Kühlsystem kostengünstig herstellbar und einfach montierbar sein.

Diese Aufgabe wird durch die Merkmale des Patentanspruchs 1 gelöst. Weitere erfindungsgemäße Ausgestaltungen und Vorteile gehen aus den Unteransprüchen hervor.

Demnach wird ein Kühlsystem zur Kühlung von Flachdisplays mit einer Vorsatzscheibe vorgeschlagen, welches einen offenen Kühlkreislauf zur Belüftung und Kühlung der Displaymodulrückwand und einen geschlossenen Kühlkreislauf zur Kühlung der Vorderseite des Displaymoduls umfasst, wobei die Kühlung im geschlossenen Kühlkreislauf durch Verteilung der Luft und Wärmeübertragung, und nicht, wie aus dem Stand der Technik bekannt, durch Luftaustausch erfolgt.

Beim offenen Kühlkreislauf wird mittels zumindest eines Lüfters Frischluft angesaugt, über die Displaymodulrückseite geblasen und über definierte Lüftungsöffnungen gezielt ausgeblasen.

Gemäß der Erfindung wird im geschlossenen Kühlkreislauf die Luft von oben nach unten frontseitig über das Displaymodul geblasen und unten wieder abgesaugt. Hierbei werden die Umlenkung und Zuführung der Luft oben sowie die Umlenkung und Absaugung der Luft unten über Teile realisiert, die vorzugsweise aus Kunststoff hergestellt sind und an Displaymodul und Frontrahmen des Flachdisplays angepasst sind.

Erfindungsgemäß ist an der Rückseite des Displaymoduls zumindest ein Luftkanal angeordnet, welcher die oben und unten vorgesehenen Teile zur Umlenkung und Luftzuführung bzw. Umlenkung und Luftabsaugung miteinander verbindet, wobei der geschlossene Kreislauf zumindest einen Lüfter aufweist, welcher in ein in den Kreislauf integriertes Teil, das vorzugsweise aus Kunststoff hergestellt ist, aufgenommen ist. Das Teil zur Aufnahme des Lüfters in vorzugsweise am unteren Ende des Luftkanals angeordnet.

Die Teile zur Umlenkung und Luftzuführung bzw. Umlenkung und Luftabsaugung sowie das Teil zur Aufnahme des Lüfters sind erfindungsgemäß entweder mit Dichtungen zu den benachbarten Teilen, z.B. zum Luftkanal, zum Frontrahmen oder zum Displaymodul abgedichtet, oder sie sind mit den benachbarten Teilen derart miteinander verbunden, dass eine Abdichtung gewährleistet ist. Beispielsweise können diese Teile und die jeweils benachbarten Teile ineinander gesteckt sein.

In vorteilhafter Weise sind der zumindest eine Luftkanal und die Teile zur Umlenkung und Luftzuführung bzw. Umlenkung und Luftabsaugung sowie das Teil zur Aufnahme des Lüfters derart ausgeführt, dass sie einfach und schnell in die Rückwand des Flachdisplays integriert werden können, wobei in Abhängigkeit von der Verlustleistung des Displaymoduls ein, zwei oder auch mehrere Luftkanäle vorgesehen sein können.

Des weiteren ist erfindungsgemäß vorgesehen, dass, um den Kühlkreislauf unabhängig von der Umgebungsluft zu gestalten, das Displaymodul seitlich d.h. an seinen Rändern zwischen der Vorsatzscheibe und dem Displaymodul abgedichtet ist, wobei die Abdichtung vorzugsweise durch ein einseitig selbstklebendes PE-Schaum-Band erfolgt. Die Abdichtung oben und unten erfolgt vorzugsweise über Kunststoffprofile mit Dichtlippen. Die Kunststoffprofile werden auf einer Seite mit Übermaß vorzugsweise als AluProfil ausgeführten Frontrahmen montiert, wobei sich gegenüberliegend die Dichtlippe befindet, die zur Rückwand abdichtet. An den Stirnseiten wird gemäß einer vorteilhaften Weiterbildung der Erfindung ein zusätzliches Teil eingesteckt, welches zu den angrenzenden Teilen abdichtet. Der Übergang zwischen den seitlichen PE-Schaumbanddichtungen und den Kunststoffprofilen mit Dichtlippe erfolgt vorzugsweise mit innen liegenden Schaumstoffteilen.

Die durch den geschlossenen Kühlkreislauf erzielte Kühlung ergibt sich durch Wärmeverteilung und Wärmeübertragung; durch freie Konvektion würde sich im oberen Bereich des Displaymoduls ein Hitzestau ergeben. Beim erfindungsgemäßen Kühlkonzept erfolgt der Luftstrom derart, dass die warme Luft von oben nach unten geblasen wird, wodurch nicht nur eine gleichmäßigere Wärmeverteilung am Display sondern auch an der Vorsatzscheibe erreicht wird. Auf diese Weise wird die relativ große Fläche der Vorsatzscheibe als Wärmetauscher benutzt.

Zudem wird durch die Teile zur Umlenkung und Luftzuführung bzw. Umlenkung und Luftabsaugung die Luft nicht bis zur Vorsatzscheibe, sondern bis zum abgedichteten Bereich geführt, wodurch auch üblicherweise auch das aus Aluminium hergestellte Profil des Frontrahmens als Kühlfläche bzw. Wärmetauscher verwendet wird.

Gemäß einer vorteilhaften Weiterbildung der Erfindung ist der zumindest eine Luftkanal auf der Rückseite, der, wie bereits erläutert die Teile zur Umlenkung und Luftzuführung bzw. Umlenkung und Luftabsaugung miteinander verbindet, aus Aluminium hergestellt, wobei er durch die Luft des externen Lüfters des offenen Kühlkreislaufs umströmt wird und auf diese Weise zur Kühlung der Luft im geschlossenen Kreislauf beiträgt.

Durch die erfindungsgemäße Konzeption wird ein Kühlsystem zur Kühlung von Flachdisplays mit einer Vorsatzscheibe zur Verfügung gestellt, welches wartungsfrei ist und Staubeintritt zwischen Vorsatzscheibe und Displaymodul verhindert. Des weiteren ist das erfindungsgemäße Kühlsystem kostengünstig herstellbar und auf einfache Weise montierbar.

Die Erfindung wird im Folgenden anhand der beigefügten Figuren beispielhaft näher erläutert. In diesen stellen dar:
- Figur 1:: Eine schematische perspektivische Ansicht der Rückseite eines Flachdisplays mit einer Vorsatzscheibe umfassend ein Kühlsystem gemäß der Erfindung, wobei um das Verständnis der Erfindung zu erleichtern, die der Rückseite zugeordneten Bleche nicht dargestellt sind;
- Figur 2:: Eine schematische perspektivische Schnittansicht durch einen Luftkanal der in Figur 1 gezeigten Ausführungsform der Erfindung;
- Figur 3:: Eine Detailansicht des unteren Bereichs des in Figur 2 gezeigten Luftkanals;
- Figur 4:: Eine Detailansicht des oberen Bereichs des in Figur 2 gezeigten Luftkanals;
- Figur 5:: Eine perspektivische Ansicht zur Veranschaulichung der Abdichtung des Displaymoduls; und
- Figur 6:: Eine perspektivische Ansicht der Rückseite eines Flachdisplays mit einer Vorsatzscheibe umfassend ein Kühlsystem gemäß der Erfindung im montierten Zustand.

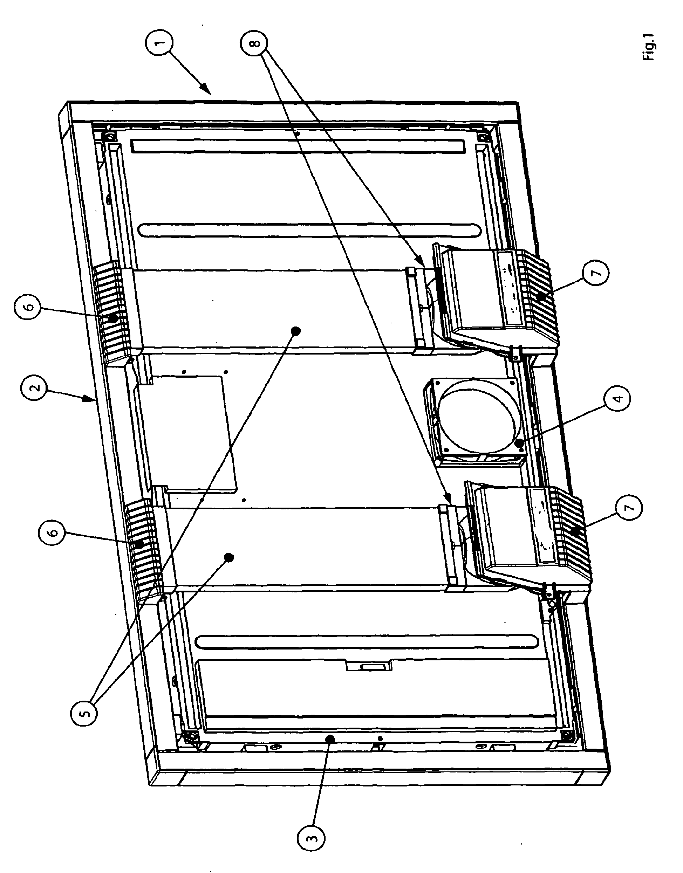

In Figur 1 ist die Rückseite eines Flachdisplays 1 mit einer Vorsatzscheibe dargestellt, wobei der Frontrahmen mit 2 und das Displaymodul mit 3 bezeichnet ist. Gemäß der Erfindung ist zur Kühlung des Flachdisplays 1 ein Kühlsystem vorgeschlagen, welches einen offenen Kühlkreislauf zur Belüftung und Kühlung der Displaymodulrückwand und einen geschlossenen Kühlkreislauf zur Kühlung der Vorderseite des Displaymoduls 3 umfasst.

Beim offenen Kühlkreislauf wird mittels zumindest eines an der Rückseite des Flachdisplays 1 vorgesehenen Lüfters, dessen Aufnahme in Figur 1 mit 4 bezeichnet ist, Frischluft angesaugt, die über die Displaymodulrückseite geblasen und über definierte Lüftungsöffnungen, die auf den der Rückseite zugeordneten, nicht dargestellten Blechen bzw. auf der Rückwand vorgesehen sind, ausgeblasen wird.

Der geschlossene Kühlkreislauf umfasst zumindest einen an der Rückseite des Displaymoduls 3 angeordneten Luftkanal 5, welcher entlang der Rückseite von unten nach oben verläuft, der an seinem unteren Ende eine aus Kunststoff hergestellte Aufnahme 8 für einen Lüfter aufweist bzw. mit einer Aufnahme 8 für den Lüfter verbunden ist, wobei der Luftkanal 5 an seinem oberen Ende mit einem Kunststoffteil 6 verbunden ist, welches der Umlenkung der vom Lüfter nach oben geblasenen Luft und der Zuführung der Luft auf die Vorderseite des Displaymoduls 3 von oben nach unten dient; ferner ist der Luftkanal 5 an seinem unteren Ende mit einem weiteren Kunststoffteil 7 verbunden, welches zum Einen als Abdeckung des Lüfters und zum Anderen der erneuten Luftumlenkung und Zuführung der Luft zum Lüfter zum Zweck der Luftabsaugung und erneuter Zuführung nach oben entlang der Rückseite des Displaymoduls dient. Die Kunststoffteile 6, 7 sind an Displaymodul 3 und Frontrahmen 3 des Flachdisplays angepasst.

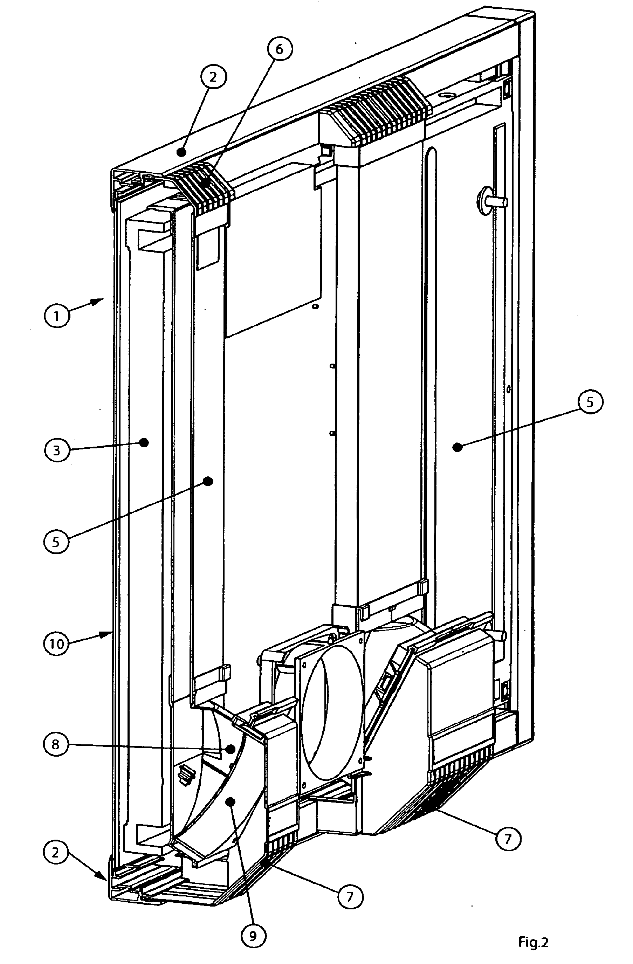

In Figur 2, welche eine schematische perspektivische Schnittansicht durch einen Luftkanal 5 darstellt, wird der Luftstrom innerhalb des geschlossenen Kühlkreislaufs des erfindungsgemäßen Kühlsystems veranschaulicht.

Hierbei wird die Luft vom in der Lüfteraufnahme 8 vorgesehenen Lüfter 9 (nur zum Teil dargestellt) nach oben entlang der Rückseite des Displaymoduls 3 geblasen, wobei die Luft durch das Kunststoffteil 6 umgelenkt wird, so dass sie entlang der Vorderseite des Displaymoduls zwischen dem Displaymodul 3 und der Vorsatzscheibe 10 nach unten strömt; am unteren Ende des Displaymoduls 3 wird die Luft vom Kunststoffteil 7 umgelenkt, vom in der Lüfteraufnahme 8 vorgesehenen Lüfter 9 abgesaugt und nach oben entlang der Rückseite des Displaymoduls 3 geblasen. Die Strömungsrichtung der Luft ist in der Figur durch die Pfeile verdeutlicht.

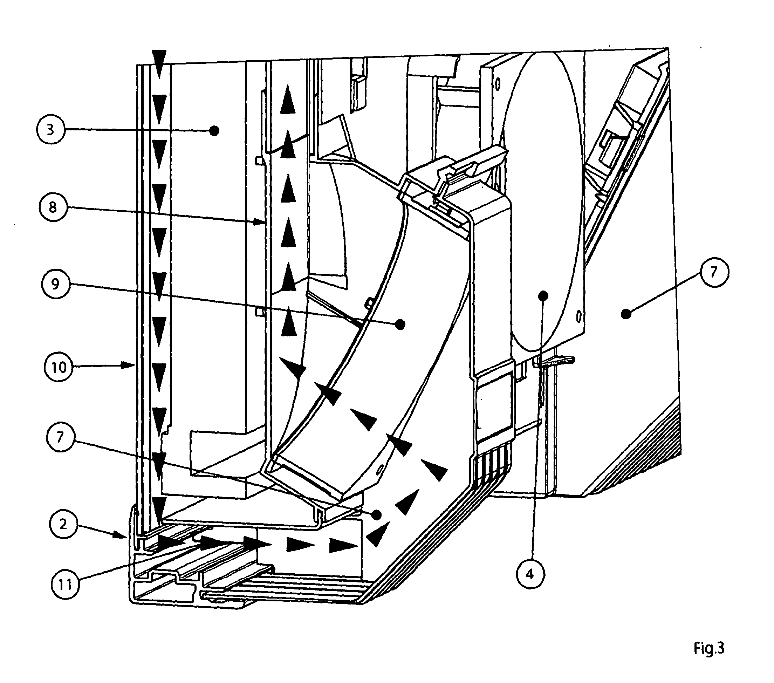

Gegenstand der Figur 3 ist eine Detailansicht des unteren Bereichs des in Figur 2 gezeigten Luftkanals 5; hierbei ist die Strömungsrichtung der Luft im geschlossenen Kühlkreislauf durch die Linie 11 in Verbindung mit dem Pfeil veranschaulicht.

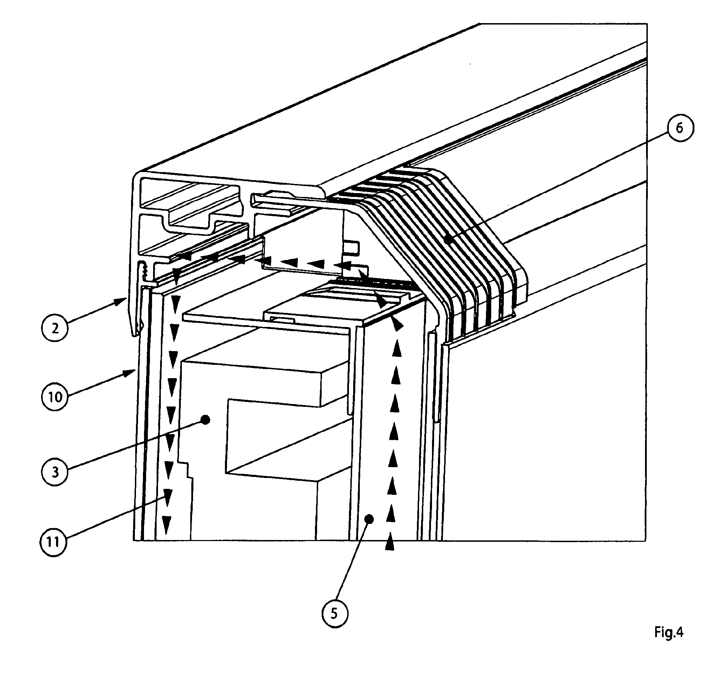

In Figur 4 ist eine Detailansicht des oberen Bereichs des in Figur 2 gezeigten Luftkanals 5 dargestellt, wobei auch in diesem Fall die Strömungsrichtung der Luft im geschlossenen Kühlkreislauf durch die Linie 11 in Verbindung mit dem Pfeil veranschaulicht wird.

Um den beschriebenen Kühlkreislauf unabhängig geschlossen bzw. unabgängig von der Umgebungsluft zu gestalten, ist das Displaymodul 3 seitlich zwischen der Vorsatzscheibe 10 und dem Displaymodul 3 abgedichtet.

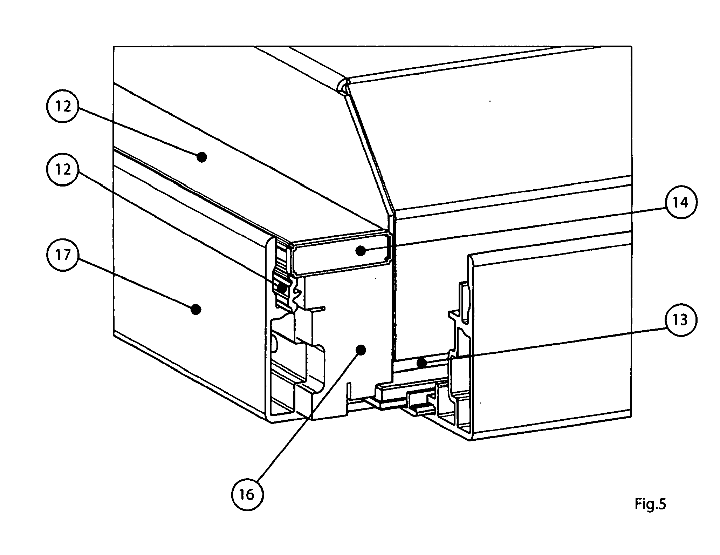

Die Abdichtung erfolgt, wie anhand Figur 5 veranschaulicht, vorzugsweise durch ein einseitig selbstklebendes PE-Schaumband 13. Oben und unten erfolgt die Abdichtung durch zumindest ein Kunststoffprofil 12 mit Dichtlippe zur Abdichtung gegenüber der Rückwand und stirnseitig eingesteckten Dichtungsstücken 14, die zu den angrenzenden Teilen abdichten. Der Übergang zwischen der innenliegenden PE-Schaumbanddichtung 13 und den außen liegenden Kunststoffprofilen 12 erfolgt durch Schaumstoffteile 16 mit Übermaß; die Kunststoffprofile sind in den Frontrahmen 2 der vorzugsweise als Aluprofil ausgeführt ist, mit Übermaß eingesteckt.

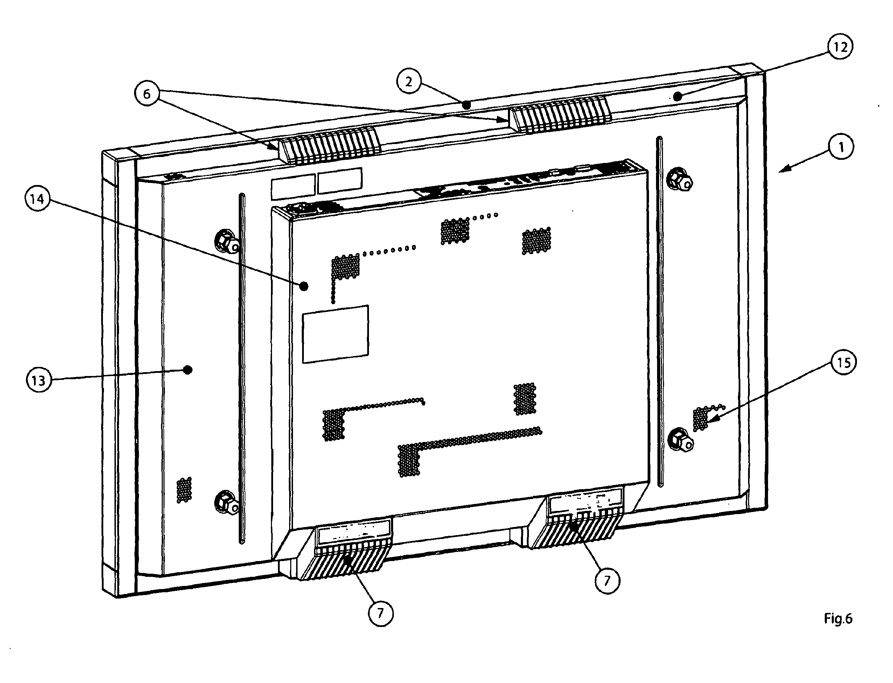

In Figur 6 ist die Rückseite eines Flachdisplays 1 mit einer Vorsatzscheibe umfassend ein Kühlsystem gemäß der Erfindung im montierten Zustand dargestellt; hierbei ist die Rückwand des Flachdisplays mit 13 und die Elektronikbox mit 14 bezeichnet. Des weiteren sind in Figur 6 die Lüftungsöffnungen 15 des offenen Kühlkreislaufs dargestellt, über die die vom Lüfter des offenen Kühlkreislaufs angesaugte Luft ausgeblasen wird.

## Patentansprüche

1. Kühlsystem zur Kühlung von Flachdisplays (1) mit einer Vorsatzscheibe (10), wobei das Kühlsystem einen offenen Kühlkreislauf und einen geschlossenen Kühlkreislauf zur Kühlung der Vorderseite des Displaymoduls (3) umfasst, wobei die Kühlung im geschlossenen Kühlkreislauf durch Luftverteilung und Wärmeübertragung erfolgt, **dadurch gekennzeichnet, dass** der offene Kühlkreislauf zur Belüftung und kühlung der Displaymodulrückwand zumindest einen an der Rückseite des Flachdisplays vorgesehenen Lüfter umfasst, mittels dessen Frischluft angesaugt wird, welche über die Displaymodulrückseite geblasen und über definierte Lüftungsöffnungen (15), die auf den der Rückseite zugeordneten Blechen bzw. auf der Rückwand vorgesehen sind, ausgeblasen wird.

2. Kühlsystem zur Kühlung von Flachdisplays (1) mit einer Vorsatzscheibe (10), nach Anspruch 1, **dadurch gekennzeichnet, dass** der geschlossene Kühlkreislauf zumindest einen an der Rückseite des Displaymoduls (3) angeordneten Luftkanal (5) umfasst, welcher entlang der Rückseite von unten nach oben verläuft und der an seinem unteren Ende eine Aufnahme (8) für einen Lüfter (9) aufweist bzw. mit einer Aufnahme (8) für den Lüfter (9) verbunden ist, wobei der Luftkanal (5) an seinem oberen Ende mit einem Teil (6) verbunden ist, welches der Umlenkung der vom Lüfter (9) nach oben geblasenen Luft und der Zuführung der Luft auf die Vorderseite des Displaymoduls (3) von oben nach unten dient und wobei der Luftkanal (5) an seinem unteren Ende mit einem weiteren Kunststoffteil (7) verbunden ist, welches als Abdeckung des Lüfters (9) und erneuten Luftumlenkung und Zuführung der Luft zum Lüfter (9) zum Zweck der Luftabsaugung und erneuter Zuführung nach oben entlang der Rückseite des Displaymoduls dient.

3. Kühlsystem zur Kühlung von Flachdisplays (1) mit einer Vorsatzscheibe (10), nach Anspruch 2, **dadurch gekennzeichnet, dass** die Teile (6, 7) sind an Displaymodul (3) und Frontrahmen (3) des Flachdisplays (1) angepasst sind.

4. Kühlsystem zur Kühlung von Flachdisplays (1) mit einer Vorsatzscheibe (10), nach Anspruch 2 oder 3, **dadurch gekennzeichnet, dass** die Teile (6, 7) und die Aufnahme (8) für den Lüfter (9) aus Kunststoff hergestellt sind.

5. Kühlsystem zur Kühlung von Flachdisplays (1) mit einer Vorsatzscheibe (10), nach Anspruch 2, 3 oder 4, **dadurch gekennzeichnet, dass** die Teile (6, 7) und die Aufnahme (8) für den Lüfter (9) über Dichtungen zu den benachbarten Teilen abgedichtet sind oder mit den benachbarten Teilen derart miteinander verbunden sind, dass eine Abdichtung gewährleistet ist.

6. Kühlsystem zur Kühlung von Flachdisplays (1) mit einer Vorsatzscheibe (10), nach Anspruch 5, **dadurch gekennzeichnet, dass** die Teile (6, 7) und die Aufnahme (8) für den Lüfter (9) und die jeweils benachbarten Teile ineinander gesteckt sind.

7. Kühlsystem zur Kühlung von Flachdisplays (1) mit einer Vorsatzscheibe (10), nach einem der vorangehenden Ansprüche, **dadurch gekennzeichnet, dass** das Displaymodul (3) seitlich zwischen der Vorsatzscheibe (10) und dem Displaymodul (3) abgedichtet ist.

8. Kühlsystem zur Kühlung von Flachdisplays (1) mit einer Vorsatzscheibe (10), nach Anspruch 7, **dadurch gekennzeichnet, dass** die Abdichtung durch ein einseitig selbstklebendes PE-Schaumband (13), durch ein Kunststoffprofil (12) mit Dichtlippe zur Abdichtung gegenüber der Rückwand und durch im Kunststoffprofil (12) stirnseitig eingesteckten Dichtungsstücken (14) erfolgt, die zu den angrenzenden Teilen abdichten, wobei der Übergang zwischen der innenliegenden PE-Schaumbanddichtung (13) und den außen liegenden Kunststoffprofilen (12) durch Schaumstoffteile (16) mit Übermaß erfolgt.

9. Kühlsystem zur Kühlung von Flachdisplays (1) mit einer Vorsatzscheibe (10), nach Anspruch 8, **dadurch gekennzeichnet, dass** die Kunststoffprofile (12) in den Frontrahmen (2) mit Übermaß eingesteckt sind.

10. Kühlsystem zur Kühlung von Flachdisplays (1) mit einer Vorsatzscheibe (10), nach einem der vorangehenden Ansprüche 2 bis 9, **dadurch gekennzeichnet, dass** der zumindest eine Luftkanal (5) aus Aluminium hergestellt ist, wobei er durch die Luft des Lüfters des offenen Kühlkreislaufs umströmt wird und zur Kühlung der Luft im geschlossenen Kreislauf beiträgt.

## Claims

1. A cooling system for cooling flat-screen displays (1) having a front-attached pane (10), wherein the cooling system comprises an open and a closed cooling circuit for cooling the front side of display module (3), and wherein cooling in the closed cooling circuit takes place by the distribution of air and the transfer of heat, **characterized in that**, for ventilating and cooling the rear surface of the display module, said open cooling circuit comprises at least one blower which is provided at the rear of the flat-screen display and by means of which fresh air is inhaled, which air is blown across the rear surface of the display module and exhaled through defined ventilation openings (15) provided in sheet-metal elements associated with said rear surface or in the rear wall.

2. Cooling system for cooling flat-screen displays (1) having a front-attached pane (10), as claimed in claim 1, **characterized by** said closed cooling circuit comprising at least one air duct (5) located on the rear of display module (3), said duct running along the rear from the bottom to the top thereof and having or being connected at its bottom end with a receptacle (8) for blower (9), said air duct (5) being connected at its top end with a part (6) which serves to deflect air blown upwardly by blower (9) and to guide said air towards the front of display module (3) from the top to the bottom thereof, and said air duct (5) being connected at its bottom end with an additional part (7) made of a plastics material which serves to cover blower (9) and to re-deflect the air and to guide it towards blower (9) for the purpose of extracting the air and again guiding it upwards across the rear surface of the display module.

3. Cooling system for cooling flat-screen displays (1) having a front-attached pane (10) as claimed in claim 2, **characterized in that** parts (6, 7) are configured to match display module (3) and front frame (3) of flat-screen display (1).

4. Cooling system for cooling flat-screen displays (1) having a front-attached pane (10), as claimed in claim 2 or 3, **characterized in that** parts (6, 7) and receptacle (8) for blower (9) are made of a plastics material.

5. Cooling system for cooling flat-screen displays (1) having a front-attached pane (10), as claimed in claim 2, 3 or 4, **characterized in that** parts (6, 7) and receptacle (8) for blower (9) are sealed from adjoining parts by sealing members or are connected with such adjoining parts in a manner to ensure a sealed relationship thereto.

6. Cooling system for cooling flat-screen displays (1) having a front-attached pane (10), as claimed in claim 5, **characterized in that** parts (6, 7) and receptacle (8) for blower (9) and the respective adjoining parts are inserted into each other

7. Cooling system for cooling flat-screen displays (1) having a front-attached pane (10), as claimed in any one of the preceding claims, **characterized in that** lateral seals are provided between front-attached pane (10) and display module (3).

8. Cooling system for cooling flat-screen displays (1) having a front-attached pane (10), as claimed in claim 7, **characterized in that** sealing is effected by means of single-coated self-adhesive PE foam tape (13), by profiled plastics strip members (12) comprising a sealing lip for sealing against the rear surface and by sealing pieces (14) inserted into the end faces of said plastics strip members (12) so as to establish a sealed connection with the adjoining parts, with the transition from the inner PE sealing tape (13) to the outer profiled plastics strip members being made by oversize foam parts (16).

9. Cooling system for cooling flat-screen displays (1) having a front-attached pane (10), as claimed in claim 8, **characterized in that** said plastic strip members are oversized when inserted in front frame (2).

10. Cooling system for cooling flat-screen displays (1) having a front-attached pane (10), as claimed in any one of the preceding claims 2 to 9, **characterized in that** said at least one air duct (5) is made of aluminum, and **in that** said duct has the air from the blower of the open cooling circuit flowing around and over it and contributes to the cooling of the air in the closed cooling circuit.

## Revendications

1. Système de refroidissement pour le refroidissement d'écrans plats (1) avec une vitre de façade (10), lequel système de refroidissement comprend un circuit de refroidissement ouvert et un circuit de refroidissement fermé pour le refroidissement de la face avant du module d'affichage (3), dans lequel le refroidissement dans le circuit fermé est réalisé par la distribution de l'air et la transmission de la chaleur, **caractérisé en ce que** le circuit de refroidissement ouvert comprend pour ventiler et refroidir la paroi arrière du module d'affichage au moins un ventilateur prévu sur la face arrière de l'écran plat, au moyen duquel de l'air frais est aspiré, qui est soufflé sur la face arrière du module d'affichage et évacué par des ouvertures d'aération (15) définies qui sont prévues sur des tôles associées à la face arrière ou sur la paroi arrière.

2. Système de refroidissement pour le refroidissement d'écrans plats (1) avec une vitre de façade (10), selon la revendication 1, **caractérisé en ce que** le circuit de refroidissement fermé comprend au moins un conduit d'air (5) disposé sur la face arrière du module d'affichage (3), qui court le long de la face arrière de bas en haut et présente à son extrémité inférieure un logement (8) pour un ventilateur (9) ou qui est relié à un logement (8) pour le ventilateur (9), le conduit d'air (5) étant relié à son extrémité supérieure à une pièce (6) qui sert à dévier l'air soufflé vers le haut par le ventilateur (9) et à l'amener vers la face avant du module d'affichage (3) du haut vers le bas et le conduit d'air (5) étant relié à son extrémité inférieure à une autre pièce en plastique (7) qui sert à couvrir le ventilateur (9) et à dévier à nouveau l'air et à l'amener vers le ventilateur (9) en vue de l'aspiration de l'air et de son renvoi vers le haut le long de la face arrière du module d'affichage.

3. Système de refroidissement pour le refroidissement d'écrans plats (1) avec une vitre de façade (10), selon la revendication 2, **caractérisé en ce que** les pièces (6, 7) sont adaptées sur le module d'affichage (3) et le cadre avant (2) de l'écran plat (1).

4. Système de refroidissement pour le refroidissement d'écrans plats (1) avec une vitre de façade (10), selon la revendication 2 ou 3, **caractérisé en ce que** les pièces (6, 7) et le logement (8) pour le ventilateur (9) sont faits de matière plastique.

5. Système de refroidissement pour le refroidissement d'écrans plats (1) avec une vitre de façade (10), selon la revendication 2, 3 ou 4, **caractérisé en ce que** les pièces (6, 7) et le logement (8) pour le ventilateur (9) sont rendus étanches par des joints vis-à-vis des pièces voisines ou sont reliés aux pièces voisines de façon à garantir une étanchéité.

6. Système de refroidissement pour le refroidissement d'écrans plats (1) avec une vitre de façade (10), selon la revendication 5, **caractérisé en ce que** les pièces (6, 7) et le logement (8) pour le ventilateur (9) et les pièces voisines sont emboîtés les uns dans les autres.

7. Système de refroidissement pour le refroidissement d'écrans plats (1) avec une vitre de façade (10), selon l'une des revendications précédentes, **caractérisé en ce que** le module d'affichage (3) est rendu étanche latéralement entre la vitre de façade (10) et le module d'affichage (3).

8. Système de refroidissement pour le refroidissement d'écrans plats (1) avec une vitre de façade (10), selon la revendication 7, **caractérisé en ce que** l'étanchéité est réalisée par une bande de mousse de polyuréthane (13) autocollante sur une face, par un profilé en matière plastique (12) avec une lèvre d'étanchéité pour assurer l'étanchéité vis-à-vis de la paroi arrière et par des éléments d'étanchéité (14) insérés sur la face avant dans le profilé en matière plastique (12) et assurant l'étanchéité vis-à-vis des pièces limitrophes, la transition entre le joint intérieur en bande de mousse de polyuréthane (13) et les profilés en matière plastique (12) extérieurs étant réalisée par des pièces en mousse (16) surdimensionnées.

9. Système de refroidissement pour le refroidissement d'écrans plats (1) avec une vitre de façade (10), selon la revendication 8, **caractérisé en ce que** les profilés en matière plastique (12) sont insérés dans le cadre avant (2) avec un surdimensionnement.

10. Système de refroidissement pour le refroidissement d'écrans plats (1) avec une vitre de façade (10), selon l'une des revendications 2 à 9, **caractérisé en ce que** l'au moins un conduit d'air (5) est fait d'aluminium, est explosé à l'air du ventilateur du circuit de refroidissement ouvert et contribue au refroidissement de l'air dans le circuit fermé.
